# FASCICULE DE BREVET EUROPEEN

(11) **EP 1 290 730 B1**
(45) Date de publication et mention de la délivrance du brevet: **12.07.2006**
(21) Numéro de dépôt: 01947499.8
(22) Date de dépôt: 06.06.2001
(51) Int. Cl.: H01L 23/538, H01L 21/48

(54) **PROCEDE POUR REALISER UNE PERMUTATION D'ENTREES/SORTIES DE PLUSIEURS PISTES A BRANCHES PARALLELES D'UN CIRCUIT INTEGRE ET CIRCUIT OBTENU**
VERFAHREN ZUR VERTAUSCHUNG VON EINGANGS-/AUSGANGS-LEITERBAHNEN MIT PARALLELEN ZWEIGEN IN EINER INTEGRIERTEN SCHALTUNG UND SOMIT ERHALTENEN INTEGRIERTE SCHALTUNG
METHOD FOR PRODUCING INPUT/OUTPUT PERMUTATION OF SEVERAL CONDUCTIVE STRIPS WITH PARALLEL BRANCHES OF AN INTEGRATED CIRCUIT AND RESULTING CIRCUIT

(30) Priorité: 09.06.2000 FR 0007400
(43) Date de publication de la demande: 12.03.2003
(73) Titulaire: CENTRE NATIONAL D'ETUDES SPATIALES, F-75001 Paris (FR)
(72) Inventeur: DESPLATS, Romain, F-31400 Toulouse (FR); BENTEO, Bruno, F-31450 Pompertuzat (FR)
(74) Mandataire: Cabinet BARRE LAFORGUE & associés
(86) Numéro de dépôt international: PCT/FR2001/001737
(87) Numéro de publication internationale: WO 2001/095394

(56) Documents cités:
- US-A- 4 652 974
- US-A- 4 974 048
- US-A- 5 815 374
- RAJAPAKSE R ET AL: "FOCUSED ION BEAM REPAIR FOR THICK FILM MULTILAYER WAFER SCALE INTERCONNECTIONS" PROCEEDINGS OF THE INTERNATIONAL VLSI MULTILEVEL INTERCONNECTION CONFERENCE,US,NEW YORK, IEEE, vol. CONF. 3, 9 juin 1986 (1986-06-09), pages 362-371, XP000010175
- HOFFMANN P ET AL: "DIRECT WRITING OF GOLD NANOSTRUCTUTES USING A GOLD-CLUSTER COMPOUNDAND A FOCUSED-ION BEAM" JOURNAL OF APPLIED PHYSICS,US,AMERICAN INSTITUTE OF PHYSICS. NEW YORK, vol. 74, no. 12, 15 décembre 1993 (1993-12-15), pages 7588-7591, XP000423034 ISSN: 0021-8979

## Description

L'invention concerne un procédé pour réaliser sur un circuit intégré après sa fabrication, une permutation d'entrées/sorties de plusieurs pistes de matériau conducteur du circuit intégré comprenant des branches, dites branches parallèles, parallèles entre elles, par une combinaison d'opérations de coupures de pistes et de dépôts de matériau conducteur et, le cas échéant, de matériau isolant. Elle s'étend à un circuit intégré susceptible d'être obtenu par un tel procédé.

Un procédé de correction d'erreurs dans un circuit intégré par re-routage de pistes, ainsi qu'un circuit intégré correspondant, est connu par le document US 4 974 048 A. Celui-ci fait appel à des pistes supplémentaires prééxistantes et à l'activation de fusibles et/ou anti-fusibles par faisceau laser.

Dans les opérations de correction des circuits intégrés après leur fabrication, notamment pour en corriger certains défauts, il est souvent nécessaire de réaliser une permutation d'entrées/sorties de plusieurs pistes conductrices. Par exemple, l'entrée d'une première piste doit être reliée à la sortie d'une deuxième piste et isolée de sa sortie initiale qui, elle, doit être reliée à l'entrée de la deuxième piste, les entrées/sorties ayant fait l'objet d'une interversion. Plus généralement, une permutation d'entrées/sorties doit parfois être réalisée sur un nombre de pistes qui peut être égal à deux, ou supérieur à deux. Les permutations à réaliser peuvent être diverses, circulaires ou non, incorporer une ou plusieurs interversions.

Dans tout le texte, le terme "interversion" désigne toute permutation d'un ensemble initial d'éléments en un ensemble permuté de ces éléments par laquelle chaque élément de l'ensemble permuté a été permuté par rapport aux éléments de l'ensemble initial, et qui ne peut pas être scindée en sous-permutations (c'est-à-dire en permutations portant sur un sous-ensemble de l'ensemble initial) ou restreinte à une sous-permutation. Une interversion est donc une permutation minimale, circulaire ou non circulaire, modifiant l'ordre de tous les éléments de l'ensemble initial.

De même, dans tout le texte, l'expression "permutation d'entrées/sorties de pistes" désigne une opération consistant à permuter les entrées d'un groupe de pistes par rapport à leurs entrées initiales et/ou les sorties d'un groupe de pistes par rapport à leurs sorties initiales. De façon traditionnelle, les entrées et sorties, ainsi que le terme "aval" et "amont" sont définis par rapport au sens de propagation du signal dans les pistes. De même, le terme "horizontal" fait référence à toute direction parallèle aux couches de matériau du circuit intégré, le terme "vertical" fait référence à toute direction orthogonale à ces couches, le substrat du circuit intégré étant supposé en bas.

La situation la plus fréquemment rencontrée lorsqu'une permutation d'entrées/sorties de plusieurs pistes doit être, faite, est celle où les pistes présentent des branches parallèles entre elles, appartenant en général à une même couche de matériau conducteur (couche de métal) ou parfois à des couches distinctes. L'ensemble des pistes dont les entrées/sorties doivent être permutées est en effet souvent représentatif d'un bus, c'est-à-dire véhicule des signaux en parallèle. Il arrive en effet que des erreurs de conception soient faites pour la réalisation de tels bus.

Lors d'une intervention de correction après fabrication sur un circuit intégré, on réalise par exemple à l'aide d'une installation à faisceau d'ions focalisé (FIB) une ou plusieurs coupure(s) de piste(s), et un ou plusieurs dépôt(s) de matériau conducteur pour relier deux pistes entre elles, et si nécessaire, un où plusieurs dépôt(s) de matériau isolant pour pouvoir réaliser ensuite un dépôt de matériau conducteur au-dessus d'une piste à nu sans liaison électrique avec cette piste.

Lors d'une telle intervention, il convient d'effectuer le minimum possible d'opérations, et de choisir les options les plus simples et les moins coûteuses. En particulier, il est avantageux de réaliser des dépôts rectilignes (sans virage, en un seul segment de droite ou avec le nombre minimum de virages), aussi courts que possible et en aussi faible nombre que possible. En outre, il est aussi avantageux d'éviter que des dépôts conducteurs successifs ne se croisent, nécessitant l'interposition entre eux d'un dépôt isolant.

En outre, pour accélérer les interventions de correction, le besoin se fait sentir de disposer de procédés systématiques performants pour les situations les plus courantes en vue notamment d'obtenir des circuits intégrés corrigés qui soient de fiabilité et qualité améliorées.

L'invention vise donc un procédé économique, rapide et systématique permettant de réaliser, sur un circuit intégré après fabrication, une permutation d'entrées/sorties de plusieurs pistes à branches parallèles (de même niveau de métal ou non au sein du circuit intégré).

L'invention vise plus particulièrement à proposer un procédé dans lequel les dépôts sont en faible nombre, aussi courts que possible, avec un nombre minimum de virages dans les dépôts conducteurs -notamment avec au plus un virage et de préférence sans virage- et dans lequel on minimise le nombre de dépôts isolants et on évite tout dépôt isolant entre deux dépôts conducteurs successifs.

L'invention vise aussi à proposer un circuit intégré de fiabilité et qualité améliorées qui a fait l'objet d'au moins une permutation d'entrées/sorties de plusieurs pistes à branches parallèles.

Pour ce faire, l'invention concerne un procédé tel que mentionné ci-dessus, caractérisé en ce que :
- on identifie, parmi les branches parallèles, au moins un groupe minimal de branches parallèles appartenant aux pistes dont les entrées/sorties doivent, dans la permutation, faire l'objet d'une interversion par rapport aux sorties/entrées des pistes auxquelles appartiennent les branches parallèles de ce groupe minimal, aucun sous-groupe de branches parallèles ne pouvant être trouvé dans ce groupe minimal, appartenant à des pistes dont les entrées/sorties doivent, dans la permutation, faire l'objet d'une interversion par rapport aux sorties/entrées des pistes auxquelles appartiennent les branches parallèles de ce même sous-groupe,
- on localise le long des branches parallèles du groupe minimal, un coude où l'une d'elles, dite branche déviée, est déviée selon un angle droit par rapport aux branches parallèles du groupe minimal, en étant prolongée à partir du coude par une branche, dite branche perpendiculaire, perpendiculaire à cette branche déviée, la branche déviée et la branche perpendiculaire appartenant à une même couche de matériau conducteur du circuit intégré,
- pour réaliser ladite interversion des entrées/sorties des pistes correspondant aux branches parallèles du groupe minimal, on se place au moins au voisinage du coude localisé et on réalise des opérations de dépôts et coupures comprenant :
   - un dépôt, dit dépôt perpendiculaire, de matériau conducteur rectiligne perpendiculaire aux branches parallèles entre la branche déviée à proximité immédiate du coude, et une branche parallèle devant être reliée à cette branche déviée pour réaliser l'interversion,
   - un dépôt, dit dépôt incliné, de matériau conducteur entre un point, dit premier point de connexion, de la branche perpendiculaire et un point, dit deuxième point de connexion, d'une branche parallèle devant être reliée à cette branche perpendiculaire pour réaliser l'interversion, ce dépôt incliné passant au-dessus au moins de la branche déviée en étant isolé de cette dernière et de toute autre piste intercalée au-dessus de laquelle ce dépôt incliné doit passer entre les points de connexion, par une couche de matériau isolant,
   - une coupure de la branche perpendiculaire entre ledit premier point de connexion et le coude,
   - une coupure à proximité immédiate du deuxième point de connexion sur une portion de la branche parallèle comprenant ce deuxième point de connexion, adjacente au dépôt incliné, et formant un angle aigu avec la direction droite passant par les points de connexion de ce dépôt incliné,
- on réitère ladite interversion pour chaque groupe minimal de branches parallèles identifié, de façon à obtenir la permutation d'entrées/sorties de toutes les pistes.

L'invention part ainsi du constat selon lequel dans tout circuit intégré, lorsque plusieurs branches parallèles initiales doivent être interverties (croisées), l'une au moins des branches -notamment celle située le plus à l'extérieur selon la direction horizontale lorsque ces branches sont de même niveau- présente toujours un coude où elle est déviée de ce groupe de branches parallèles. Il est certain en effet qu'un circuit intégré ne présente pas des pistes toujours toutes parallèles, sans déviation, d'un côté à l'autre du circuit intégré.

Avantageusement et selon l'invention, les branches parallèles appartenant toutes à une même couche de matériau conducteur, la branche déviée est située le plus à l'extérieur dans cette couche par rapport aux branches parallèles du groupe minimal et est déviée selon un angle droit vers l'extérieur de ces branches parallèles, la branche perpendiculaire s'éloignant dans cette couche à partir du coude vers l'extérieur des branches parallèles du groupe minimal.

L'invention est néanmoins aussi applicable si les branches parallèles appartiennent à des niveaux différents (couches différentes). Dans ce cas, au sein d'une même couche contenant la branche déviée, s'il y a plusieurs branches parallèles, la branche perpendiculaire s'éloigne vers l'extérieur des branches parallèles et la branche déviée est située le plus à l'extérieur des branches parallèles de cette même couche.

Egalement, le procédé de l'invention s'applique aussi bien lorsque les branches parallèles d'une même couche sont adjacentes (sans interposition d'autres pistes entre elles), ou lorsqu'elles ne sont pas adjacentes.

Par ailleurs, selon une caractéristique préférentielle de l'invention, on localise le coude le plus en amont par rapport au sens de propagation du signal dans les branches parallèles, et on se place au moins au voisinage de ce coude pour réaliser les opérations de dépôts et de coupures. Cela étant, la branche perpendiculaire peut prolonger la branche déviée aussi bien vers l'amont ou vers l'aval par rapport au sens de propagation du signal.

L'invention s'applique en particulier avantageusement au cas d'un circuit intégré passivé comprenant une couche isolante supérieure.

Avantageusement et selon l'invention, on réalise les dépôts de matériau conducteur au-dessus de ladite couche isolante supérieure du circuit intégré après avoir réalisé, au moins à travers cette couche, des puits de connexion mettant à nu des portions des pistes à relier.

Par ailleurs, avantageusement et selon l'invention, on relie deux branches parallèles toutes deux distinctes de la branche déviée par un dépôt perpendiculaire, c'est-à-dire un dépôt de matériau conducteur rectiligne perpendiculaire à ces branches parallèles, et on réalise une coupure à l'amont de ce dépôt perpendiculaire sur l'une de ces branches parallèles et une coupure à l'aval de ce dépôt perpendiculaire sur l'autre de ces branches parallèles.

Selon une caractéristique préférentielle de l'invention, le procédé est caractérisé en ce que :
- on réalise tout d'abord le(s) dépôt(s) perpendiculaire(s) en commençant par celui relié à la branche déviée et, le cas échéant, de proche en proche à partir de ce dépôt perpendiculaire sur chaque paire de branches parallèles qui se jouxtent,
- on réalise ensuite le dépôt incliné,
- on réalise ensuite les coupures.

Lesdites branches parallèles se jouxtent en ce sens qu'il n'y a pas entre elles d'autres branches parallèles appartenant audit groupe minimal.

En outre, avantageusement et selon l'invention, au moins un dépôt incliné est formé d'un seul segment rectiligne incliné par rapport à la direction des branches parallèles.

En variante, au moins un dépôt incliné est formé de deux segments rectilignes dont l'un est perpendiculaire à la direction des branches parallèles.

Le deuxième segment peut être incliné, ou parallèle à la direction des branches parallèles.

Dans le cas où la permutation doit intervenir uniquement sur deux pistes, elle consiste simplement à réaliser un croisement de deux branches parallèles formant ledit groupe minimal. La permutation peut aussi, en variante, consister en plusieurs interversions (croisements) de paires de branches parallèles. Chaque paire de branches parallèles à croiser est un groupe minimal. Elle peut aussi, dans une autre variante, consister en une interversion, circulaire ou non, sur plus de deux branches parallèles formant un groupe minimal, ou comprendre une telle interversion ou plusieurs telles interversions. Toutes les combinaisons de ces variantes sont envisageables.

Avantageusement et selon l'invention, on réalise les opérations de dépôts et coupures à l'aide d'une installation à au moins un faisceau d'ions focalisé FIB.

L'invention s'étend à un circuit intégré obtenu après correction par un procédé selon l'invention. L'invention concerne donc aussi un circuit intégré comprenant des branches parallèles, dites branches, parallèles entre elles et appartenant à des pistes de matériau conducteur, dont au moins l'une d'elles, dite branche déviée, présente au moins un coude où elle est déviée selon un angle droit par rapport aux branches parallèles d'un groupe minimal de branches parallèles, en étant prolongée par une branche, dite branche perpendiculaire, perpendiculaire à cette branche déviée, le coude à angle droit étant formé entre cette branche déviée et cette branche perpendiculaire, la branche déviée et la branche perpendiculaire appartenant à une même couche de matériau du circuit intégré, caractérisé en ce qu'il comprend, au moins au voisinage d'au moins un coude d'une branche déviée :
- un dépôt, dit dépôt perpendiculaire de matériau conducteur rectiligne perpendiculaire aux branches parallèles entre la branche déviée à proximité immédiate du coude, et une branche parallèle ainsi reliée à la branche déviée,
- un dépôt, dit dépôt incliné, de matériau conducteur entre un point, dit premier point de connexion, de la branche perpendiculaire et un point, dit deuxième point de connexion, d'une branche parallèle ainsi reliée à cette branche perpendiculaire, ce dépôt incliné passant au-dessus au moins de la branche déviée en étant isolé de cette dernière, et de toute autre piste intercalée au-dessus de laquelle ce dépôt incliné doit passer entre les points de connexion, par une couche de matériau isolant,
- une coupure de la branche perpendiculaire entre ledit premier point de connexion et le coude,
- une coupure à proximité immédiate du deuxième point de connexion sur une portion de la branche parallèle comprenant ce deuxième point de connexion, adjacente au dépôt incliné, et formant un angle aigu avec la direction droite passant par les points de connexion de ce dépôt incliné,
de sorte que les entrées/sorties des pistes comprenant ces branches parallèles ont fait l'objet d'une interversion, par l'intermédiaire de ces dépôts et coupures, par rapport aux sorties/entrées de ces mêmes pistes.

Avantageusement et selon l'invention, les dépôts sont formés au-dessus d'une couche isolante supérieure de passivation du circuit et sont reliés aux branches par des puits de connexion traversant au moins cette couche isolante supérieure. Avantageusement et selon l'invention, les branches parallèles appartiennent à la même couche de matériau du circuit intégré, la branche déviée est située le plus à l'extérieur dans cette couche par rapport aux branches parallèles du groupe minimal et est déviée selon un angle droit vers l'extérieur de ces branches parallèles, la branche perpendiculaire s'éloignant dans cette couche à partir du coude vers l'extérieur des branches parallèles du groupe minimal.

L'invention concerne aussi un procédé et un circuit intégré caractérisés en combinaison par tout ou partie des caractéristiques mentionnées ci-dessus ou ci-après.

D'autres buts, caractéristiques et avantages de l'invention apparaissent de la description suivante d'exemples dé réalisation qui se réfère aux figures annexées dans lesquelles :
- la figure 1 est un schéma illustrant un procédé et un circuit selon l'invention d'interversion des entrées/sorties de deux pistes à branches parallèles adjacentes, la branche perpendiculaire étant à l'amont de la branche déviée,
- la figure 2 est un schéma illustrant une variante de la figure 1 dans laquelle la branche perpendiculaire est à l'aval de la branche déviée,
- la figure 3 est un schéma illustrant un procédé et un circuit selon l'invention dans un exemple de permutation circulaire sur quatre pistes,
- la figure 4 est un schéma illustrant un procédé et un circuit selon l'invention dans un autre exemple de permutation circulaire sur quatre pistes,
- la figure 5 est un schéma illustrant un procédé et un circuit selon l'invention dans un exemple de permutation sur quatre pistes avec deux interversions juxtaposées,
- la figure 6 est un schéma illustrant un procédé et un circuit selon l'invention dans un exemple de permutation sur quatre pistes avec deux interventions imbriquées,
- les figures 7 et 8 sont des schémas illustrant respectivement deux variantes de la figure 6,
- les figures 9 et 10 sont des schémas illustrant respectivement deux variantes d'un procédé selon l'invention pour une permutation circulaire d'entrées/sorties sur un groupe minimal de cinq pistes,
- les figures 11 et 12 sont des schémas illustrant, respectivement, deux variantes d'un procédé selon l'invention pour une permutation non circulaire d'éntrées/sorties sur un groupe de cinq branches parallèles, correspondant à deux interversions circulaires sur des groupes minimaux de deux et trois branches parallèles.

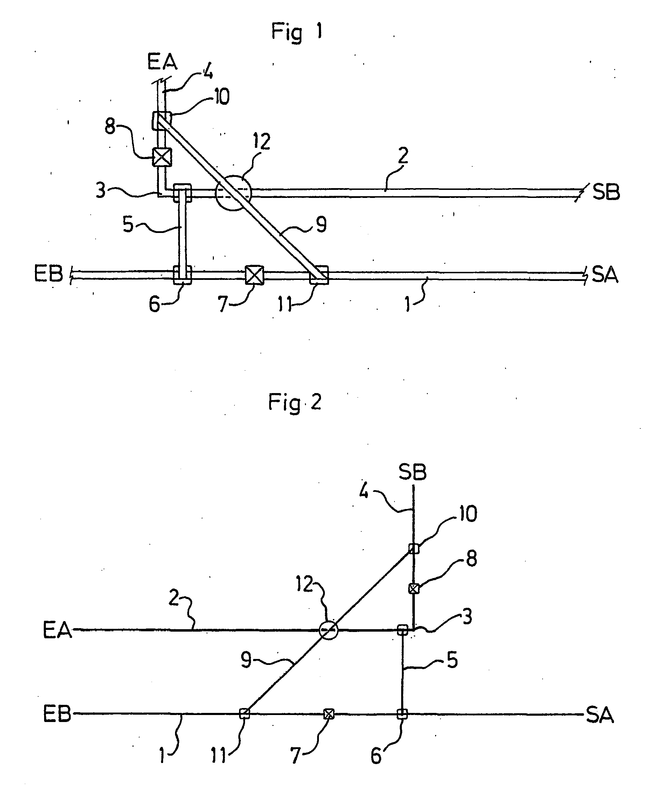

Sur les figures, on a représenté une portion de schéma de circuit intégré. Cette représentation est faite, de façon traditionnelle, vue du côté de la face supérieure, les différentes pistes étant supposées être situées dans le même niveau de métal (même couche de matériau conducteur). Néanmoins, dans le cadre de l'invention, cette condition n'est aucunement nécessaire, les différentes pistes pouvant appartenir à différents niveaux de métal. Il suffit en effet dans ce cas, de prévoir des puits de connexion de profondeur appropriée pour atteindre chacune des pistes à relier. Sur les figures 2 à 12, la représentation, des pistes a été simplifiée (simples traits) par rapport à celle de la figure 1 où la largeur des pistes est figurée.

Sur les figures, on a représenté l'état du schéma après correction, c'est-à-dire après avoir mis en oeuvre le procédé selon l'invention. Le circuit intégré comprend des branches parallèles entre elles, chaque branche appartenant à une piste, et présentant une entrée du signal EA, EB, EC, ED, EE, et une sortie pour le signal SA, SB, SC, SD, SE. Toutes les entrées sont en général situées du même côté du circuit intégré et toutes les sorties sont également situées du même côté. Sur les figures, on suppose que le signal se propage de gauche à droite dans les différentes branches parallèles.

Dans toute la description qui suit en référence aux figures, les termes "supérieur" et "inférieur" sont utilisés par rapport au plan des figures, et non par rapport à la direction verticale du circuit intégré.

Dans le cas de la figure 1, le circuit comprend une branche rectiligne inférieure 1 et une branche rectiligne supérieure 2 qui présente, du côté de son entrée, un coude 3 à partir duquel elle est prolongée par une branche perpendiculaire 4 s'éloignant de la branche inférieure 1. Initialement, l'entrée de la branche perpendiculaire 4 est reliée électriquement avec la sortie de la branche supérieure 2, et l'entrée de la branche inférieure 1 est reliée à la sortie de la branche inférieure 1. L'invention permet d'inverser les sorties et les entrées de ces branches. Pour ce faire, on réalise un dépôt de matériau conducteur 5 rectiligne, perpendiculaire aux deux branches inférieures et supérieures 1, 2 s'étendant à partir du coude 3 de la branche supérieure 2 jusqu' à rejoindre la branche inférieure 1 en un point de connexion 6. On réalise une coupure 7 à l'aval du point de connexion 6 sur la branche inférieure 1 et une coupure 8 à l'amont du coude 3 sur la branche perpendiculaire 4. On réalise un dépôt incliné 9 s'étendant depuis un point de connexion 10 de la branche perpendiculaire 4 à l'amont de la coupure 8 jusqu'à un point de connexion 11 de la branche inférieure 1 à l'aval de la coupure 7. Ce dépôt incliné 9 traverse donc l'angle droit formé par le coude 3 et passe au-dessus de la branche supérieure 2, tout en étant isolé de cette branche supérieure 2 soit par la couche de passivation supérieure du circuit intégré (dans le cas d'un circuit passivé) soit, si la branche supérieure 2 est à nu, par l'intermédiaire d'un dépôt de matériau isolant 12. Comme on le voit, on a ainsi interverti les sorties SA et SB par rapport aux entrées EA et EB initiales.

La figure 2 représente un schéma semblable dans le cas où le coude 3 est situé du côté de la sortie de la branche supérieure 2, la branche perpendiculaire 4 étant reliée du côté de la sortie à cette branche supérieure 2. La branche perpendiculaire 4 s'étend donc à l'aval de la branche déviée 2. On réalise encore un dépôt perpendiculaire 5 entre le coude 3 et un point de connexion 6 de la branche inférieure 1 ; une coupure 7 sur la branche inférieure 1, qui est située dans ce cas à l'amont du point de connexion 6 du dépôt perpendiculaire 5 ; une coupure 8 sur la branche perpendiculaire 4 à l'aval du coude 3 ; et un dépôt incliné 9 qui s'étend entre un point de connexion 10 à la branche perpendiculaire 4, qui est situé à l'aval de la coupure 8, et un point de connexion 11 à la branche inférieure 1, situé à l'amont de la coupure 7. L'entrée EB de la branche inférieure 1 est reliée à la sortie SB de la branche perpendiculaire 4 par l'intermédiaire du dépôt incliné 9 tandis que l'entrée EA de la branche supérieure 2 est reliée à la sortie SA de la branche inférieure 1 par le dépôt perpendiculaire 5. Là encore, si nécessaire, un dépôt isolant 12 est interposé entre la branche supérieure 2 et le dépôt incliné 9.

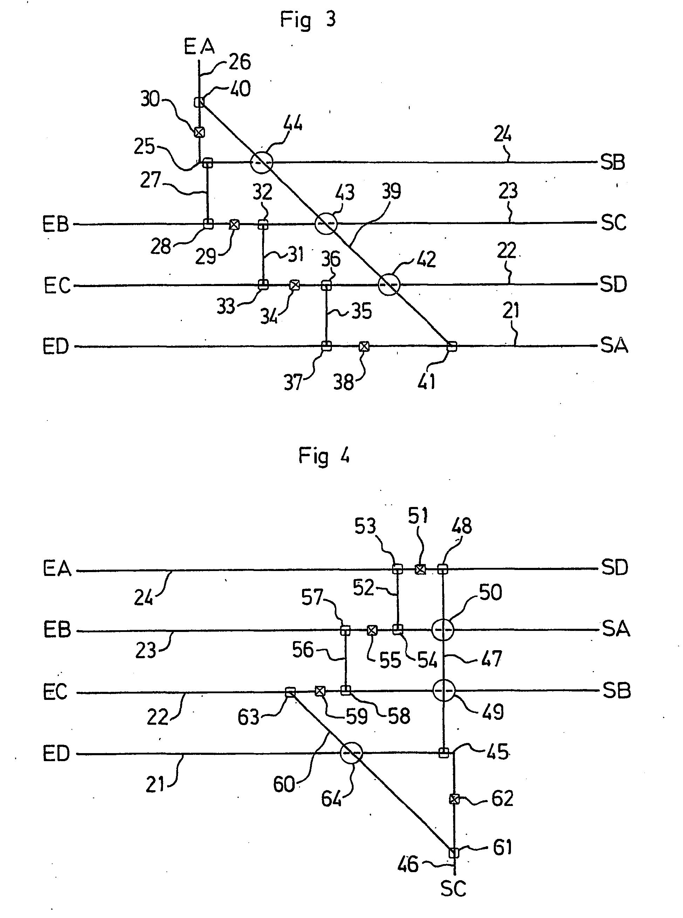

La figure 3 représente un exemple de permutation circulaire pouvant être obtenue avec un groupe minimal de quatre branches parallèles 21, 22, 23, 24, la branche parallèle supérieure 24 présentant un coude 25 du côté de son entrée, et étant prolongée à partir du coude 25 par une branche perpendiculaire 26 s'étendant à l'amont 4 de la branche déviée 24. On réalise un dépôt perpendiculaire de matériau conducteur 27 entre le coude 25 et la branche parallèle 23 immédiatement adjacente, qui jouxte la branche déviée 24. Le dépôt 27 rejoint cette piste 23 en un point de connexion 28 à l'aval duquel on réalise une coupure 29. On réalise également une coupure 30 à l'amont du coude 25 sur la branche perpendiculaire 26. Un dépôt perpendiculaire de matériau conducteur 31 est réalisé entre un point de connexion 32 à l'aval de la coupure 29 sur la branche parallèle 23, jusqu'à rejoindre la branche parallèle 22 immédiatement adjacente qui jouxte cette branche parallèle 23, en un point de connexion 33 à l'aval duquel on réalise une coupure 34. De même un dépôt perpendiculaire conducteur 35 est réalisé entre la branche parallèle 22 et la branche parallèle inférieure 21, entre un point de connexion 36 à la branche parallèle 22, et un point de connexion 37 à la branche parallèle inférieure 21 à l'aval duquel on réalise une coupure 38. Un dépôt incliné 39 est réalisé depuis un point de connexion 40 sur la branche perpendiculaire 26 à l'amont de la coupure 30 de cette branche perpendiculaire 26, jusqu'à un point de connexion 41 de la branche parallèle inférieure 21, à l'aval de sa coupure 28. Ce dépôt incliné 39 passe au-dessus des branches parallèles 24, 23, 22 dont il est isolé soit par la couche de passivation, soit par des dépôts isolants 42, 43, 44 respectivement. Un seul dépôt isolant continu peut aussi être réalisé au-dessus des différentes pistes 22, 23, 24 suivant le trajet du dépôt incliné 39. Comme on le voit, ce procédé permet d'intervertir les sorties SA, SB, SC, SD selon une permutation circulaire, par rapport aux entrées EA, EB, EC, ED des différentes branches parallèles 21, 22, 23, 24. Ainsi, l'entrée EA de la branche perpendiculaire 26 est reliée via le dépôt incliné 39 à la sortie SA de la branche parallèle inférieure 21 ; l'entrée EB de la branche parallèle 23 est reliée à la sortie SB de la branche parallèle supérieure 24, l'entrée EC de la branche parallèle 22 est reliée à la sortie SC de la branche parallèle 23, et l'entrée ED de la branche parallèle 21 est reliée à la sortie SD de la branche parallèle 22 immédiatement supérieure.

La figure 4 représente un autre exemple de situation d'un groupe minimal de quatre branches parallèles 21, 22, 23, 24. Néanmoins, dans cet exemple, c'est la branche parallèle inférieure 21 qui est déviée vers l'extérieur et forme un coude 45 avec une branche perpendiculaire 46 s'étendant à l'aval de la branche déviée 21. En outre, on a représenté un exemple dans lequel la branche déviée 21 doit être reliée à la branche parallèle 24 qui est la plus éloignée dans le groupe, tandis que la branche perpendiculaire 46 doit être reliée à la branche parallèle 22 immédiatement adjacente à la branche déviée 21. Dans ce cas, et contrairement à l'exemple de la figure 3, on réalise un dépôt perpendiculaire 47 qui traverse les deux branches parallèles médianes 22, 23 intermédiaires et relie donc le coude 45 à la branche parallèle supérieure 24 en un point de connexion 48. Ce dépôt perpendiculaire 47 passe au-dessus des branches 22, 23, dont il est isolé soit par la couche de passivation, soit par des dépôts isolants 49, 50, respectivement. Là encore, un seul dépôt isolant en forme de bandes de grandes dimensions peut être effectué plutôt que deux dépôts isolants localisés 49, 50. Une coupure 51 est réalisée à l'amont du point 48 sur la branche parallèle supérieure 24, et un dépôt perpendiculaire 52 relie cette branche 24, depuis un point de connexion 53 à l'amont de la coupure 51 jusqu'à un point de connexion 54 à la branche parallèle 23 immédiatement inférieure. Une coupure 55 est réalisée sur cette branche parallèle 23 immédiatement en amont du point de connexion 54. Un dépôt 56 relie un point de connexion 57 à l'amont de la coupure 55 de la branche parallèle 23 à un point de connexion 58 sur la branche parallèle 22 immédiatement adjacente. Une coupure 59 est réalisée à l'amont du point de liaison 58 sur la branche parallèle 22. Un dépôt incliné 60 relie un point de connexion 61 de la branche perpendiculaire 46 à l'aval d'une coupure 62 qui est elle-même à l'aval du coude 45, jusqu'à un point de connexion 63 de la branche parallèle 22 immédiatement adjacente à la branche parallèle 21. Le dépôt incliné 60 est isolé des la branche déviée 21 par la couche de passivation ou par un dépôt isolant 64. Comme on le voit, les sorties SA, SB, SC, SD sont interverties selon une permutation circulaire par rapport aux entrées EA, EB, EC, ED.

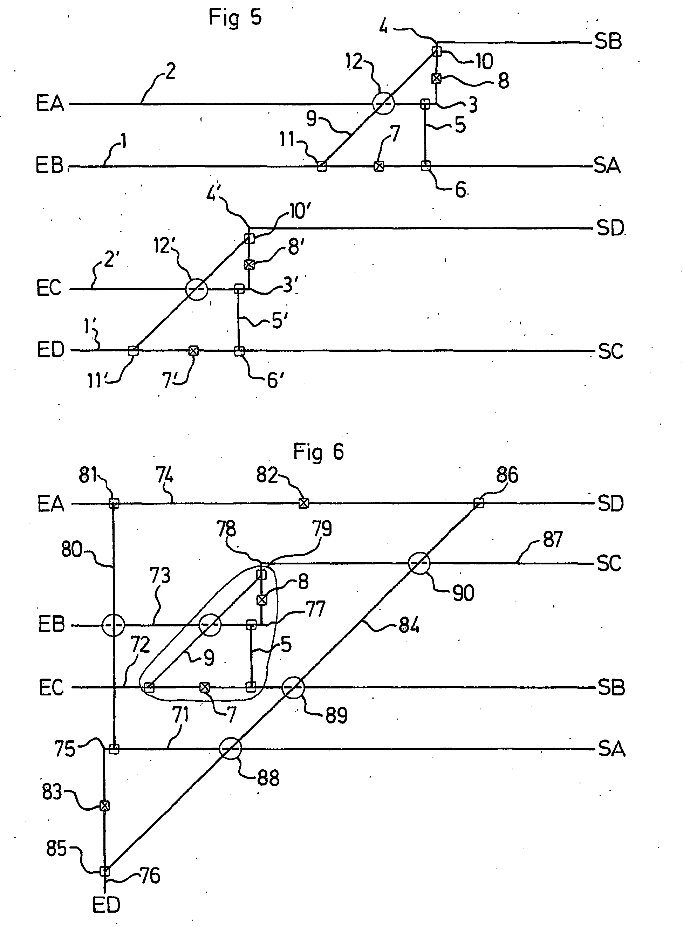

La figure 5 illustre le cas d'une permutation sur quatre branches parallèles 1', 2', 1, 2 qui n'est en fait qu'une duplication de la situation de la figure 2. Ainsi, cette permutation consiste en deux interversions, chaque interversion étant formée sur un groupe minimal 1, 2 ou 1', 2'. On réalise donc comme dans le cas de la figure 2, un dépôt perpendiculaire 5, 5' entre le coude 3, 3' et un point de connexion 6, 6' de la branche parallèle 1, 1'; les coupures 7, 7' à l'amont des points de connexion 6, 6', et 8, 8' à l'aval des coudes 3, 3', sur les branches perpendiculaires 4, 4' ; et un dépôt incliné 9, 9' entre les points de connexion 10, 10' des branches perpendiculaires 4, 4' et les points de connexion 11, 11' à l'amont des coupures 7, 7' des branches parallèles 1, 1'. Le cas échéant, un dépôt isolant 12, 12' est également prévu entre le dépôt incliné 9, 9' et la branche parallèle déviée 2, 2'. Dans cet exemple, les deux interversions sont réalisées séparément sur deux paires de branches parallèles 1, 2 et 1', 2', qui se jouxtent.

Dans la variante de la figure 6, la permutation est également formée de deux interversions sur deux groupes minimaux de branches parallèles intercalés l'un dans l'autre. Ainsi, on doit intervertir deux branches parallèles extérieures 71, 74 entre elles, et deux branches parallèles intérieures 72, 73 entre elles. La branche parallèle extérieure 71 présente un coude 75 à partir duquel elle est prolongée par une branche perpendiculaire 76 s'étendant vers l'extérieur vers l'amont. La branche parallèle intérieure 73 supérieure présente un coude 77 à partir duquel elle est prolongée vers l'extérieur (en direction de la branche parallèle extérieure 74 supérieure) vers l'aval par une branche perpendiculaire 78. Pour le groupe minimal formé par les deux branches parallèles intérieures 72, 73, on retrouve la situation de la figure 2, et on réalise donc le dépôt perpendiculaire 5 et le dépôt incliné 9 ainsi que les coupures 7, 8 comme décrit précédemment. Ce faisant, l'ensemble de ces opérations définit une zone 79 délimitée schématiquement figure 6 qui doit être évitée pour réaliser l'interversion sur les branches parallèles extérieures 71, 74. Dans le cas de la figure 6, le coude 75 étant situé bien en amont de cette zone 79, on peut réaliser un dépôt perpendiculaire 80 directement entre le coude 75 et un point de connexion 81 de la branche parallèle extérieure supérieure 74. Une coupure 82 est ménagée à l'aval du point 81 sur cette branche parallèle 74, et une coupure 83 est ménagée à l'amont du coude 75 sur la branche perpendiculaire 76. Un dépôt incliné 84 est réalisé entre un premier point de connexion 85 à l'amont de la coupure 83 sur la branche perpendiculaire 76 et un deuxième point de connexion 86 sur la branche parallèle extérieure supérieure 74, à l'aval de la coupure 82. Le dépôt incliné 84 est situé à l'aval de la zone 79, tandis que le dépôt perpendiculaire 80 est situé à l'amont de la zone 79. Autrement dit, dans cet exemple, la zone 79 dans laquelle on intervertit les branches parallèles intérieures 72, 73 est intercalé entre le dépôt perpendiculaire 80 et le dépôt incliné 84 permettant d'intervertir les branches parallèles extérieures 71, 74. Le dépôt incliné passe au-dessus des branches parallèles 71, 72 et d'un prolongement 87 de la branche perpendiculaire 78 s'étendant parallèlement aux branches parallèles. Le dépôt incliné 84 est isolé de ces branches 71, 72, 87 par la couche de passivation, ou par des dépôts isolants 88, 89, 90 respectivement.

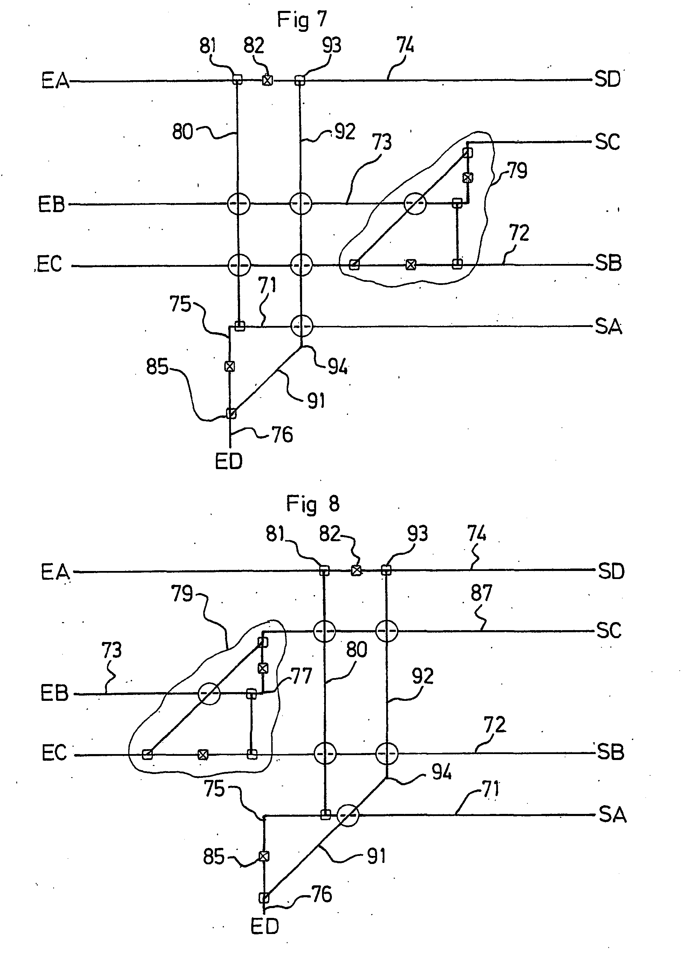

La figure 7 représente un exemple semblable au précédent, mais dans lequel on a remplacé le dépôt incliné 84 ayant un seul segment, par un dépôt incliné formé de deux segments 91, 92, à savoir un segment incliné 91 par rapport aux branches parallèles 71, 72, 73, 74 prolongé par un deuxième segment 92 perpendiculaire aux branches parallèles 71, 72, 73, 74, et s'étendant à l'amont de la zone 79 d'interversion des branches intérieures. Le dépôt incliné 91, 92 ainsi formé est donc constitué de deux segments rectilignes, à savoir un segment incliné 91 s'étendant depuis le premier point point de connexion 85 sur la branche perpendiculaire 76 et un segment perpendiculaire 92 s'étendant entre un deuxième point de connexion 93 de la branche parallèle extérieure supérieure 74 pour rejoindre le segment incliné 91 en un point de connexion 94. Il est à noter néanmoins que la coupure 82 sur la branche parallèle 74 comprenant le deuxième point de connexion 93 est effectuée sur la portion de la branche 74 formant un angle aigu avec la droite (fictive) passant par le premier et le deuxième points de connexion 85, 93. Cette variante permet de raccourcir la longueur du dépôt incliné ainsi formé par rapport à celui de la figure 6.

La figure 8 représente une autre variante dans laquelle les coudes 75, 77 sont situés au moins sensiblement dans la même zone transversale. Dans ce cas, on décale le dépôt perpendiculaire 80 et le dépôt incliné 91, 92 (ou 84 comme sur la figure 6) vers l'aval de la zone 79 d'interversion des branches parallèles intérieures 71, 72.

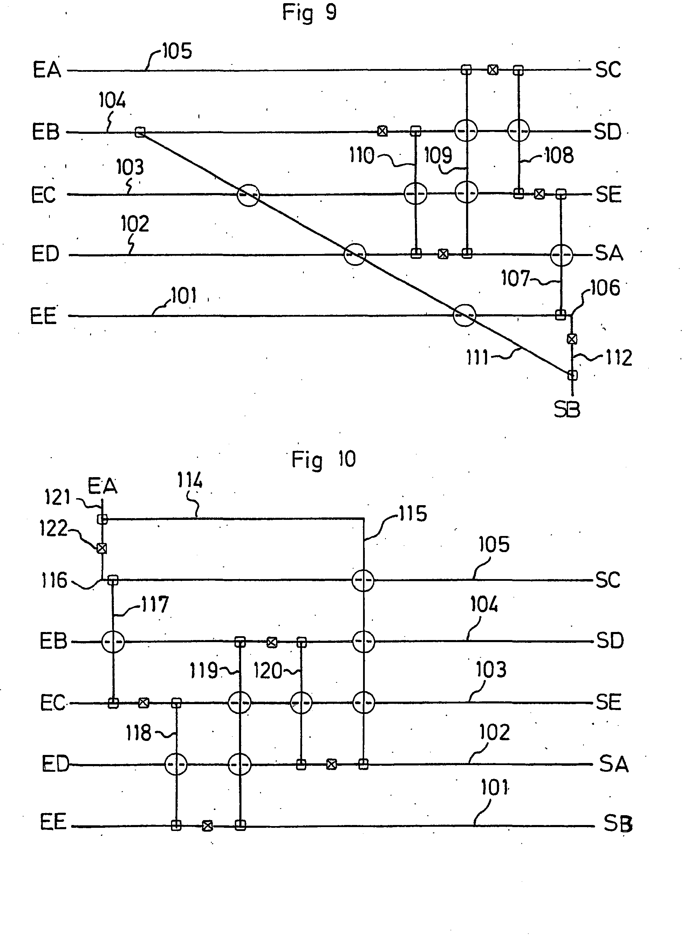

La figure 9 représente un exemple général de permutation circulaire sur cinq branches 101, 102, 103, 104, 105 formant un groupe minimal. Pour intervertir les sorties SA, SB, SC, SD, SE par rapport aux entrées EA, EB, EC, ED, EE, on se place au coude 106 de la branche extérieure 101 déviée, on réalise le dépôt conducteur 107 jusqu'à la branche parallèle 103 devant être relié à la branche déviée 101, puis, de proche en proche, chaque dépôt conducteur perpendiculaire 108, 109, 110, après avoir réalisé les coupures correspondantes. On réalise le dépôt incliné 111 entre la branche perpendiculaire 112 et la branche parallèle 104 à laquelle elle doit être reliée. Comme on le voit, dans toutes les situations, il est possible de trouver une série de dépôts perpendiculaires 107, 108, 109, 110 et un dépôt incliné 111 de matériau conducteur, qui ne se chevauchent pas. L'ensemble de ces dépôts conducteurs peut donc être réalisé au-dessus de la couche de passivation.

La figure 10 représente un autre exemple de permutation circulaire dans lequel on remplace le dépôt incliné 111 par deux segments 114, 115 rectilignes dont l'un 114 est parallèle aux branches parallèles 101 à 105 tandis que l'autre 115 est perpendiculaire à ces branches parallèles 101 à 105. Là encore, à partir du coude 116 de la branche déviée 105; on réalise les dépôts perpendiculaires conducteurs 117, 118, 119, 120, successivement, avec les coupures correspondantes, puis le dépôt incliné 114, 115 à partir de la branche perpendiculaire 121 (à l'amont de la coupure 122 réalisée à l'amont du coude 116).

L'invention s'applique aussi au cas d'une permutation formée d'une interversion non circulaire, de la même manière.

L'invention s'applique aussi au cas d'une permutation se décomposant en une réunion d'interversions circulaires ou non. Dans ce cas, on recherche les groupes minimaux sur lesquels on peut réaliser des interversions, et pour chaque groupe minimal ainsi trouvé, on réalise l'interversion en localisant un coude sur la branche extérieure de ce groupe minimal comme décrit ci-dessus.

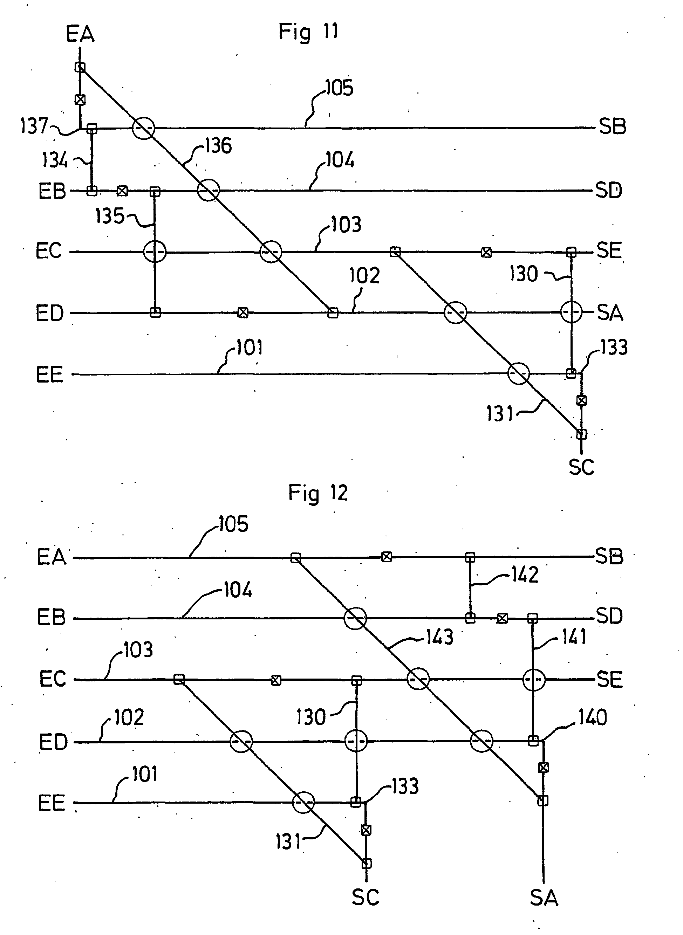

Les figures 11 et 12 représentent des exemples de permutation non circulaire composée de la réunion de deux interversions circulaires. Pour chaque interversion, on réalise un dépôt incliné. Sur la figure 11, les deux branches déviées sont, respectivement, les deux branches parallèles extérieures 101, 105. On réalise une interversion entre les branches parallèles 101, 103 (premier groupe minimal) grâce à un dépôt perpendiculaire 130 et un dépôt incliné 131 au niveau du coude 133 de la branche déviée 101. On réalise par ailleurs une interversion entre les branches parallèles 102, 104 et 105 (deuxième groupe minimal) grâce à deux dépôts perpendiculaires 134, 135 et un dépôt incliné 136 au niveau du coude 137 de la branche parallèle déviée 105.

La figure 12 représente la même permutation que dans la figure 11, mais dans le cas où les coudes sont situés sur des branches parallèles adjacentes 101, 102. On fait également le dépôt perpendiculaire 130 à partir du coude 133 de la branche parallèle extérieure 101, ainsi que le dépôt incliné correspondant comme décrit figure 11. La branche 102 étant déviée et présentant un coude 140, on réalise deux dépôts perpendiculaires 141 et 142 et un dépôt incliné 143 par rapport à ce coude 140, pour obtenir la deuxième interversion.

En variante non représentée, l'un des dépôts inclinés 131, 143 ou les deux, peut (peuvent) être formé(s) de deux segments rectilignes, comme sur les figures 7, 8 ou 10.

Comme on le voit, l'invention procure une méthode systématique permettant de réaliser toute permutation, circulaire ou non, entre les sorties et les entrées d'un groupe de branches parallèles. Pour chaque interversion circulaire ou non, comprise dans ladite permutation, on utilise un coude de l'une des branches du groupe minimal correspondant et l'on réalise un dépôt incliné comme décrit ci-dessus à partir de ce coude.

Les différents dépôts réalisés ne se chevauchent pas les uns les autres et ont tous une longueur réduite.

L'invention peut faire l'objet de très nombreuses variantes par rapport aux seuls exemples de réalisation représentés et décrits ci-dessus.

Chaque coupure et chaque dépôt peuvent être réalisés grâce à une installation de faisceaux d'ions focalisés (FIB) bien connu en soi (par exemple du type SCHLUMBERGER IDS P3X).

La localisation des coudes peut être effectuée par l'opérateur humain à partir d'un affichage d'une représentation des pistes sur l'écran géré par le système informatique de l'installation FIB. Néanmoins, les coudes peuvent être aussi localisés de façon automatique à l'aide par exemple des polygones extraits représentant les pistes, comme décrit par US-5.192.222.

Il est à noter que l'on a décrit ci-dessus l'ordre logique dans lequel on détermine les différentes opérations à effectuer. Cet ordre logique ne correspond néanmoins pas nécessaires à l'ordre dans lequel on effectue, dans la réalité, ces différentes opérations successivement en pratique. En effet, il est préférable d'effectuer tout d'abord toutes les opérations de dépôt successivement, de préférence en commençant par le dépôt conducteur perpendiculaire à partir du coude, puis tous les dépôts perpendiculaires successivement, en terminant par le dépôt incliné conducteur, puis d'effectuer ensuite les coupures de piste. En réalisant tous les dépôts avant les coupures, on évite ainsi d'effectuer un dépôt conducteur à l'intérieur d'une coupure.

## Revendications

1. Procédé pour réaliser sur un circuit intégré après sa fabrication, une permutation d'entrées/sorties de plusieurs pistes de matériau conducteur du circuit intégré comprenant des branches, dites branches parallèles, parallèles entre elles, par une combinaison d'opérations de coupures de pistes et de dépôts de matériau conducteur et de matériau isolant, **caractérisé en ce que** :
- on identifie, parmi les branches parallèles (1, 2, 1', 2', 21 à 24, 71 à 74, 101 à 105), au moins un groupe minimal (1, 2 ou 1', 2', ou 21 à 24, ou 71 à 74, ou 101, 103, ou 102, 104, 105, ou 101 à 105) de branches parallèles appartenant aux pistes dont les entrées/sorties doivent, dans la permutation, faire l'objet d'une interversion par rapport aux sorties/entrées des pistes auxquelles appartiennent les branches parallèles de ce groupe minimal, aucun sous-groupe de branches parallèles ne pouvant être trouvé dans ce groupe minimal, appartenant à des pistes dont les entrées/sorties doivent, dans la permutation, faire l'objet d'une interversion par rapport aux sorties/entrées des pistes auxquelles appartiennent les branches parallèles de ce même sous-groupe,
- on localise le long des branches parallèles du groupe minimal, un coude (3, 3', 25, 45, 75, 77, 106, 116, 133, 137, 140) où l'une d'elles, dite branche déviée, est déviée selon un angle droit par rapport aux branches parallèles du groupe minimal, en étant prolongée à partir du coude par une branche, dite branche perpendiculaire (4, 4', 26, 46, 76, 112, 121), perpendiculaire à cette branche déviée, la branche déviée et la branche perpendiculaire appartenant à une même couche de matériau conducteur du circuit intégré,
- pour réaliser ladite interversion des entrées/sorties des pistes correspondant aux branches parallèles du groupe minimal, on se place au moins au voisinage du coude localisé et on réalise des opérations de dépôts et coupures comprenant :
• un dépôt, dit dépôt perpendiculaire (5, 5', 27, 47, 80, 107, 117, 130, 134, 141), de matériau conducteur rectiligne perpendiculaire aux branches parallèles entre la branche déviée à proximité immédiate du coude, et une branche parallèle devant être reliée à cette branche déviée pour réaliser l'interversion,
• un dépôt, dit dépôt incliné (9, 9', 39, 60, 84, 91, 92, 111, 114, 115, 131, 136, 143), de matériau conducteur entre un point, dit premier point de connexion, de la branche perpendiculaire et un point, dit deuxième point de connexion, d'une branche parallèle devant être reliée à cette branche perpendiculaire pour réaliser l'interversion, ce dépôt incliné passant au-dessus au moins de la branche déviée en étant isolé de cette dernière et de toute autre piste intercalée au-dessus de laquelle ce dépôt incliné doit passer entre les points de connexion, par une couche de matériau isolant,
• une coupure (8, 8', 30, 62, 83, 122) de la branche perpendiculaire entre ledit premier point de connexion et le coude,
• une coupure (7, 7', 38, 59, 82) à proximité immédiate du deuxième point de connexion sur une portion de la branche parallèle comprenant ce deuxième point de connexion, adjacente au dépôt incliné, et formant un angle aigu avec la direction droite passant par les points de connexion de ce dépôt incliné,
- on réitère ladite interversion pour chaque groupe minimal de branches parallèles identifié, de façon à obtenir la permutation d'entrées/sorties de toutes les pistes.

2. Procédé selon la revendication 1, **caractérisé en ce que** les branches parallèles (1, 2, 1', 2', 21 à 24, 71 à 74, 101 à 105) appartenant toutes à une même couche de matériau conducteur, la branche déviée est située le plus à l'extérieur dans cette couche par rapport aux branches parallèles du groupe minimal et est déviée selon un angle droit vers l'extérieur de ces branches parallèles, la branche perpendiculaire s'éloignant dans cette couche à partir du coude vers l'extérieur des branches parallèles du groupe minimal.

3. Procédé selon l'une des revendications l' ou 2, **caractérisé en ce qu'**on localise le coude (3, 3', 25, 45, 75, 77, 106, 116, 133, 137, 140) le plus en amont par rapport au sens de propagation du signal dans les branches parallèles, et on se place au moins au voisinage de ce coude pour réaliser les opérations de dépôts et de coupures.

4. Procédé selon l'une des revendications 1 à 3, dans lequel le circuit intégré comprend une couche isolante supérieure, **caractérisé en ce qu'**on réalise les dépôts de matériau conducteur (5, 5', 27, 47, 80, 107, 117, 130, 134, 141, 9, 9', 39, 60, 84, 91, 92, 111, 114, 115, 131, 136, 143) au-dessus de la couche isolante supérieure du circuit intégré après avoir réalisé, au moins à travers cette couche, des puits de connexion mettant à nu des portions des pistes à relier.

5. Procédé selon l'une des revendications 1 à 4, **caractérisé en ce que** l'on relie deux branches parallèles (22, 23 ; 21, 22) toutes deux distinctes de la branche déviée (24) par un dépôt perpendiculaire (31, 35) de matériau conducteur rectiligne perpendiculaire à ces branches parallèles, et on réalise une coupure à l'amont de ce dépôt perpendiculaire sur l'une de ces branches parallèles et une coupure (34, 38) à l'aval de ce dépôt perpendiculaire sur l'autre de ces branches parallèles.

6. Procédé selon l'une des revendications 1 à 5, **caractérisé en ce que**:
- on réalise tout d'abord le(s) dépôt(s) perpendiculaire(s) (5, 5', 27, 47, 80, 107, 117, 130, 134, 141) en commençant par celui relié à la branche déviée et, le cas échéant, de proche en proche à partir de ce dépôt perpendiculaire sur chaque paire de branches parallèles qui se jouxtent,
- on réalise ensuite le dépôt incliné (9, 9', 39, 60, 84, 91, 92, 111,114,115,131,136,143),
- on réalise ensuite les coupures (8, 8', 30, 62, 83, 122, 7, 7', 38,59,82).

7. Procédé selon l'une des revendications 1 à 6, **caractérisé en ce qu'**au moins un dépôt incliné (9, 9', 39, 60, 84, 111, 131, 136, 143) est formé d'un seul segment rectiligne incliné par rapport à la direction des branches parallèles.

8. Procédé selon l'une des revendications 1 à 7, **caractérisé en ce qu'**au moins un dépôt incliné (91, 92, 114, 115) est formé de deux segments rectilignes dont l'un (92, 115) est perpendiculaire à la direction des branches parallèles.

9. Procédé selon l'une des revendications 1 à 8, **caractérisé en ce qu'**on réalise les opérations de dépôts et coupures à l'aide d'une installation à au moins un faisceau d'ions focalisés FIB.

10. Circuit intégré comprenant des branches, dites branches parallèles (1, 2, 1', 2', 21 à 24, 71 à 74, 101 à 105), parallèles entre elles appartenant à des pistes de matériau conducteur, dont au moins l'une d'elles, dite branche déviée, présente au moins un coude (3, 3', 25, 45, 75, 77, 106, 116, 133, 137, 140) où elle est déviée selon un angle droit par rapport aux branches parallèles d'un groupe minimal de branches parallèles, en étant prolongée par une branche, dite branche perpendiculaire, perpendiculaire à cette branche déviée, le coude à angle droit étant formé entre cette branche déviée et cette branche perpendiculaire, la branche déviée et la branche perpendiculaire appartenant à une même couche de matériau du circuit intégré, **caractérisé en ce qu'**il comprend au moins au voisinage d'au moins un coude d'une branche déviée :
- un dépôt, dit dépôt perpendiculaire (5, 5', 27, 47, 80, 107, 117, 130, 134, 141), de matériau conducteur rectiligne perpendiculaire aux branches parallèles entre la branche déviée à proximité immédiate du coude, et une branche parallèle ainsi reliée à la branche déviée,
- un dépôt, dit dépôt incliné (9, 9', 39, 60, 84, 91, 92, 111, 114, 115, 131, 136, 143), de matériau conducteur entre un point, dit premier point de connexion, de la branche perpendiculaire et un point, dit deuxième point de connexion, d'une branche parallèle ainsi reliée à cette branche perpendiculaire, ce dépôt incliné passant au-dessus au moins de la branche déviée en étant isolé de cette dernière, et de toute autre piste intercalée au-dessus de laquelle ce dépôt incliné doit passer entre les points de connexion, par une couche de matériau isolant,
- une coupure (8, 8', 30, 62, 83, 122) de la branche perpendiculaire entre ledit premier point de connexion et le coude,
- une coupure (7, 7', 38, 59, 82) à proximité immédiate du deuxième point de connexion sur une portion de la branche parallèle comprenant ce deuxième point de connexion, adjacente au dépôt incliné, et formant un angle aigu avec la direction droite passant par les points de connexion de ce dépôt incliné, de sorte que les entrées/sorties des pistes comprenant ces branches parallèles ont fait l'objet d'une interversion, par l'intermédiaire de ces dépôts et coupures, par rapport aux sorties/éntrées de ces mêmes pistes.

11. Circuit selon la revendication 10, **caractérisé en ce que** les dépôts (5, 5', 27, 47, 80, 107, 117, 130, 134, 141, 9, 9', 39, 60, 84, 91, 92, 111, 114, 115, 131, 136, 143) sont formés au-dessus d'une couche isolante supérieure du circuit et sont reliés aux branches par des puits de connexion traversant au moins cette couche isolante supérieure.

12. Circuit selon l'une des revendications 10 ou 11, **caractérisé en ce que** les branches parallèles (1, 2, 1', 2', 21 à 24, 71 à 74, 101 à 105) appartiennent à la même couche de matériau du circuit intégré, la branche déviée est située le plus à l'extérieur dans cette couche par rapport aux branches parallèles du groupe minimal et est déviée selon un angle droit vers l'extérieur de ces branches parallèles, la branche perpendiculaire s'éloignant dans cette couche à partir du coude vers l'extérieur des branches parallèles du groupe minimal.

13. Circuit selon l'une des revendications 10 à 12, **caractérisé en ce qu'**au moins un dépôt incliné (9, 9', 39, 60, 84, 111, 131, 136, 143) est formé d'un seul segment rectiligne incliné par rapport à la direction des branches parallèles.

14. Circuit selon l'une des revendications 10 à 12, **caractérisé en ce qu'**au moins un dépôt incliné (91, 92, 114, 115) est formé de deux segments rectilignes dont l'un (92, 115) est perpendiculaire à la direction des branches parallèles.

## Claims

1. Method for producing, on an integrated circuit after manufacture, an input/output permutation of multiple tracks of conductive material of the integrated circuit, comprising the branches, called parallel branches, which are parallel to each other, by a combination of operations to break tracks and to deposit conductive material and insulating material, **characterized in that**:
- among the parallel branches (1, 2, 1', 2', 21 to 24, 71 to 74, 101 to 105), at least one minimal group (1, 2, or 1', 2', or 21 to 24, or 71 to 74, or 101, 103, or 102, 104, 105, or 101 to 105) of parallel branches belonging to the tracks of which the inputs/outputs must, in the permutation, be subjected to a swap in relation to the outputs/inputs of the tracks to which the parallel branches of this minimal group belong is identified, it not being possible to find a subgroup of parallel branches in this minimal group, belonging to tracks of which the inputs/outputs must, in the permutation, be subjected to a swap in relation to the outputs/inputs of the tracks to which the parallel branches of this subgroup belong,
- along the parallel branches of the minimal group, a bend (3, 3', 25, 45, 75, 77, 106, 116, 133, 137, 140) where one of them, called the deflected branch, is deflected by a right angle in relation to the parallel branches of the minimal group is located, this being prolonged from the bend by a branch, called the perpendicular branch (4, 4', 26, 46, 76, 112, 121), which is perpendicular to this deflected branch, the deflected branch and the perpendicular branch belonging to the same layer of conductive material of the integrated circuit,
- to produce the said swap of the inputs/outputs of the tracks corresponding to the parallel branches of the minimal group, depositing and breaking operations are carried out at least adjacent to the located bend, comprising:
• a rectilinear deposit, called the perpendicular deposit (5, 5', 27, 47, 80, 107, 117, 130, 134, 141), of conductive material, perpendicular to the parallel branches between the deflected branch immediately adjacent to the bend, and a parallel branch which must be connected to this deflected branch to produce the swap,
• a deposit, called the inclined deposit (9, 9', 39, 60, 84, 91, 92, 111, 114, 115, 131, 136, 143), of conductive material between a point, called the first connection point, of the perpendicular branch and a point, called the second connection point, of a parallel branch which must be connected to this perpendicular branch to produce the swap, this inclined deposit passing above at least the deflected branch, and being insulated from it, and from any other intermediate track above which this inclined deposit must pass between the connection points, by a layer of insulating material,
• a break (8, 8', 30, 62, 83, 122) of the perpendicular branch between the said first connection point and the bend,
• a break (7, 7', 38, 59, 82) immediately adjacent to the second connection point on a portion of the parallel branch including this second connection point, adjacent to the inclined deposit, and forming an acute angle with the straight direction passing through the connection points of this inclined deposit,
- this swap is repeated for each identified minimal group of parallel branches, so as to obtain the permutation of inputs/outputs of all the tracks.

2. Method according to claim 1, **characterized in that** given that the parallel branches (1, 2, 1', 2', 21 to 24, 71 to 74, 101 to 105) all belong to the same layer of conductive material, the deflected branch is the furthest out in this layer in relation to the parallel branches of the minimal group, and is deflected by a right angle towards the outside of these parallel branches, the perpendicular branch extending within this layer from the bend to the outside of the parallel branches of the minimal group.

3. Method according to one of claims 1 or 2, **characterized in that** the most upstream bend (3, 3', 25, 45, 75, 77, 106, 116, 133, 137, 140) in relation to the direction of propagation of the signal in the parallel branches is located, and depositing and breaking operations are carried out at least adjacent to this bend.

4. Method according to one of claims 1 to 3, in which the integrated circuit includes an upper insulating layer, **characterized in that** deposits of conductive material (5, 5', 27, 47, 80, 107, 117, 130, 134, 141, 9, 9', 39, 60, 84, 91, 92, 111, 114, 115, 131, 136, 143) are made above the upper insulating layer of the integrated circuit after making, at least through this layer, connecting holes baring the portions of tracks to be connected.

5. Method according to one of claims 1 to 4, **characterized in that** two parallel branches (22, 23; 21, 22), both distinct from the deflected branch (24), are connected by a perpendicular deposit (31, 35) of rectilinear conductive material, perpendicular to these parallel branches, a break is made upstream from this perpendicular deposit on one of these parallel branches, and a break (34, 38) is made downstream from this perpendicular deposit on the other of these parallel branches.

6. Method according to one of claims 1 to 5, **characterized in that**:
- the perpendicular deposit(s) (5, 5', 27, 47, 80, 107, 117, 130, 134, 141) are made first, beginning with the one which is connected to the deviated branch, and if appropriate step by step from this perpendicular deposit on each pair of adjoining parallel branches,
- the inclined deposit is made next (9, 9', 39, 60, 84, 91, 92, 111, 114, 115, 131, 136, 143),
- then the breaks are made (8, 8', 30, 62, 83, 122, 7, 7', 38, 59, 82).

7. Method according to one of claims 1 to 6, **characterized in that** at least one inclined deposit (9, 9', 39, 60, 84, 111, 131, 136, 143) is formed of a single rectilinear segment which is inclined in relation to the direction of the parallel branches.

8. Method according to one of claims 1 to 7, **characterized in that** at least one inclined deposit (91, 92, 114, 115) is formed of two rectilinear segments, one (92, 115) of which is perpendicular to the direction of the parallel branches.

9. Method according to one of claims 1 to 8, **characterized in that** depositing and breaking operations are carried out using at least one focused ion beam (FIB) facility.

10. Integrated circuit comprising branches, called parallel branches (1, 2, 1', 2', 21 to 24, 71 to 74, 101 to 105), which are parallel to each other and belong to tracks of conductive material, of which at least one, called the deflected branch, has at least one bend (3, 3', 25, 45, 75, 77, 106, 116, 133, 137, 140) where it is deflected by a right angle in relation to the parallel branches of a minimal group of parallel branches, being prolonged by a branch, called the perpendicular branch, which is perpendicular to this deflected branch, the right-angled bend being formed between this deflected branch and this perpendicular branch, the deflected branch and the perpendicular branch belonging to the same layer of material of the integrated circuit, **characterized in that** it comprises, at least adjacent to at least one bend of a deflected branch:
- a rectilinear deposit, called the perpendicular deposit (5, 5', 27, 47, 80, 107, 117, 130, 134, 141), of conductive material, perpendicular to the parallel branches between the deflected branch which is immediately adjacent to the bend, and a parallel branch which is thus connected to the deflected branch,
- a deposit, called the inclined deposit (9, 9', 39, 60, 84, 91, 92, 111, 114, 115, 131, 136, 143), of conductive material between a point, called the first connection point, of the perpendicular branch and a point, called the second connection point, of a parallel branch which is thus connected to this perpendicular branch, this inclined deposit passing above at least the deflected branch, and being insulated from it, and from any other intermediate track above which this inclined deposit must pass between the connection points, by a layer of insulating material,
- a break (8, 8', 30, 62, 83, 122) of the perpendicular branch between the said first connection point and the bend,
- a break (7, 7', 38, 59, 82) immediately adjacent to the second connection point on a portion of the parallel branch including this second connection point, adjacent to the inclined deposit, and forming an acute angle with the straight direction passing through the connection points of this inclined deposit, in such a way that the inputs/outputs of the tracks which comprise these parallel branches have been subjected to a swap, by means of these deposits and breaks, in relation to the outputs/inputs of the said tracks.

11. Circuit according to claim 10, **characterized in that** the deposits (5, 5', 27, 47, 80, 107, 117, 130, 134, 141, 9, 9', 39, 60, 84, 91, 92, 111, 114, 115, 131, 136, 143) are formed above an upper insulating circuit layer, and are connected to the branches by connecting holes which pass through at least this upper insulating layer.

12. Circuit according to one of claims 10 or 11, **characterized in that** the parallel branches (1, 2, 1', 2', 21 to 24, 71 to 74, 101 to 105) belong to the same layer of conductive material of the integrated circuit, the deflected branch is the furthest out in this layer in relation to the parallel branches of the minimal group, and is deflected by a right angle towards the outside of these parallel branches, the perpendicular branch extending within this layer from the bend to the outside of the parallel branches of the minimal group.

13. Circuit according to one of claims 10 to 12, **characterized in that** at least one inclined deposit (9, 9', 39, 60, 84, 111, 131, 136, 143) is formed of a single rectilinear segment which is inclined in relation to the direction of the parallel branches.

14. Circuit according to one of claims 10 to 12, **characterized in that** at least one inclined deposit (91, 92, 114, 115) is formed of two rectilinear segments, one (92, 115) of which is perpendicular to the direction of the parallel branches.

## Patentansprüche

1. Verfahren, um nach der Herstellung einer integrierten Schaltung auf dieser eine Vertauschung der Ein-/Ausgänge von mehreren ihrer Leiterbahnen zu realisieren, die parallel zueinander verlaufende Zweige umfasst, parallele Zweige genannt, durch eine Kombination von Vorgängen des Schneidens von Bahnen und des Auftragens von Leitermaterial und von Isoliermaterial, **dadurch gekennzeichnet, dass**:
- unter den parallelen Zweigen (1, 2, 1', 2', 21 bis 24, 71 bis 74, 101 bis 105) wenigstens eine Minimalgruppe (1, 2 oder 1', 2' oder 21 bis 24 oder 71 bis 74 oder 101, 103 oder 102, 104, 105 oder 101 bis 105) von parallelen Zweigen identifiziert wird, die zu Bahnen gehören, deren Ein-/Ausgänge bei der Vertauschung in Bezug auf die Ein-/Ausgänge von Bahnen invertiert werden sollen, zu denen die parallelen Zweige dieser Minimalgruppe gehören, wobei sich in dieser Minimalgruppe keine Untergruppe von parallelen Zweigen befinden kann, die zu Bahnen gehört, deren Ein-/Ausgänge bei der Vertauschung in Bezug auf die Ein-/Ausgänge von Bahnen invertiert werden sollen, zu denen die parallelen Zweige derselben Untergruppe gehören,
- entlang den parallelen Zweigen der Minimalgruppe eine Krümmung (3, 3', 25, 45, 75, 77, 106, 116, 133, 137, 140) lokalisiert wird, oder einer davon, abweichender Zweig genannt, in einem rechten Winkel in Bezug auf die parallelen Zweige der Minimalgruppe abweicht und von der Krümmung durch einen Zweig, lotrechter Zweig (4, 4', 26, 46, 76, 112, 121) genannt, lotrecht zu diesem abweichenden Zweig verlängert wird, wobei der abweichende Zweig und der lotrechte Zweig zur selben Leitermaterialschicht der integrierten Schaltung gehören,
- zum Realisieren der genannten Inversion von Ein-/Ausgängen von Bahnen, die den parallelen Zweigen der Minimalgruppe entsprechen, wenigstens in der Nähe der lokalisierten Krümmung Auftrags- und Schneidoperationen vorgenommen werden, die Folgendes umfassen:
• einen Auftrag, lotrechter Auftrag (5, 5', 27, 47, 80, 107, 117, 130, 134, 141) genannt, von geradlinigem Leitermaterial lotrecht zu den parallelen Zweigen zwischen dem abweichenden Zweig in unmittelbarer Nähe der Krümmung und einem parallelen Zweig, der mit diesem abweichenden Zweig verbunden werden soll, um die Inversion durchzuführen,
• einen Auftrag, geneigter Auftrag (9, 9', 39, 60, 84, 91, 92, 111, 114, 115, 131, 136, 143) genannt, des Leitermaterials zwischen einem Punkt, erster Verbindungspunkt genannt, des lotrechten Zweigs und einem Punkt, zweiter Verbindungspunkt genannt, eines parallelen Zweigs, der mit diesem lotrechten Zweig verbunden werden soll, um die Inversion durchzuführen, wobei dieser geneigte Auftrag zumindest oberhalb dem abweichenden Zweig passiert und durch eine Isoliermaterialschicht von diesem und von jeder anderen dazwischen liegenden Bahn isoliert ist, oberhalb derer dieser geneigte Auftrag zwischen den Verbindungspunkten passieren muss,
• einen Schnitt (8, 8', 30, 62, 83, 122) des lotrechten Zweigs zwischen dem ersten Verbindungspunkt und der Krümmung,
• einen Schnitt (7, 7', 38, 59, 82) in unmittelbarer Nähe zum zweiten Verbindungspunkt auf einem Abschnitt des parallelen Zweigs, der diesen zweiten Verbindungspunkt aufweist, der an dem geneigten Auftrag angrenzt und einen spitzen Winkel mit der Geraden bildet, die durch die Verbindungspunkte dieses geneigten Auftrags verläuft,
- die genannte Inversion für jede identifizierte Minimalgruppe von parallelen Zweigen wiederholt wird, um die Ein-/Ausgänge aller Bahnen zu vertauschen.

2. Verfahren nach Anspruch 1, **dadurch gekennzeichnet, dass** die parallelen Zweige (1, 2, 1', 2', 21 bis 24, 71 bis 74, 101 bis 105) alle zur selben Leitermaterialschicht gehören, der abweichende Zweig sich am weitesten außen in dieser Schicht in Bezug auf die parallelen Zweige der Minimalgruppe befindet und in einem rechten Winkel zur Außenseite dieser parallelen Zweige hin abweicht, wobei sich der lotrechte Zweig in dieser Schicht von der Krümmung zur Außenseite der parallelen Zweige der Minimalgruppe entfernt.

3. Verfahren nach Anspruch 1 oder 2, **dadurch gekennzeichnet, dass** die Krümmung (3, 3', 25, 45, 75, 77, 106, 116, 133, 137, 140) am weitesten oberhalb in Bezug auf die Ausbreitungsrichtung des Signals in den parallelen Zweigen positioniert und wenigstens in der Nähe dieser Krümmung platziert wird, um die Auftrags- und Schneidvorgänge zu realisieren.

4. Verfahren nach einem der Ansprüche 1 bis 3, wobei die integrierte Schaltung eine obere Isolierschicht umfasst, **dadurch gekennzeichnet, dass** die Leitermaterialaufträge (5, 5' , 27, 47, 80, 107, 117, 130, 134, 141, 9, 9', 39, 60, 84, 91, 92, 111, 114, 115, 131, 136, 143) oberhalb der oberen Isolierschicht der integrierten Schaltung erfolgen, nachdem Anschlussinseln wenigstens durch diese Schicht realisiert wurden, die Abschnitte von zu verbindenden Bahnen freilegen.

5. Verfahren nach einem der Ansprüche 1 bis 4, **dadurch gekennzeichnet, dass** zwei parallele Zweige (22, 23; 21, 22), die sich beide von dem abweichenden Zweig (24) unterscheiden, durch einen lotrechten Auftrag (31, 35) aus geradlinigem Leitermaterial lotrecht zu diesen parallelen Zweigen verbunden werden und ein Schnitt oberhalb dieses lotrechten Auftrags an einem dieser parallelen Zweige und ein Schnitt (34, 38) unterhalb dieses lotrechten Auftrags an dem anderen dieser parallelen Zweige vorgenommen werden.

6. Verfahren nach einem der Ansprüche 1 bis 5, **dadurch gekennzeichnet, dass**:
- zunächst der/die lotrechte(n) Auftrag/Aufträge (5, 5', 27, 47, 80, 107, 117, 130, 134, 141) erfolgt/erfolgen, wobei mit dem begonnen wird, der mit dem abweichenden Zweig verbunden ist, und ggf. schrittweise von diesem lotrechten Auftrag zu jedem Nachbarpaar von parallelen Zweigen gegangen wird,
- dann der geneigte Auftrag (9, 9', 39, 60, 84, 91, 92, 111, 114, 115, 131, 136, 143) erfolgt,
- dann die Schnitte (8, 8', 30, 62, 83, 122, 7, 7', 38, 59, 82) erfolgen.

7. Verfahren nach einem der Ansprüche 1 bis 6, **dadurch gekennzeichnet, dass** wenigstens ein geneigter Auftrag (9, 9', 39, 60, 84, 111, 131, 136, 143) in einem einzigen geradlinigen Segment ausgebildet ist, das in Bezug auf die Richtung der parallelen Zweige geneigt ist.

8. Verfahren nach einem der Ansprüche 1 bis 7, **dadurch gekennzeichnet, dass** wenigstens ein geneigter Auftrag (91, 92, 114, 115) von zwei geradlinigen Segmenten gebildet wird, von denen eines (92, 115) lotrecht zur Richtung der parallelen Zweige verläuft.

9. Verfahren nach einem der Ansprüche 1 bis 8, **dadurch gekennzeichnet, dass** die Auftrags- und Schnittvorgänge mittels einer Vorrichtung mit wenigstens einem Feinfokus-Ionenstrahlenbündel (FIB) erfolgt.

10. Integrierte Schaltung, die zueinander parallele Zweige, parallele Zweige (1, 2, 1', 2', 21 bis 24, 71 bis 74, 101 bis 105) genannt, die zu Materialleiterbahnen gehören, umfasst, von denen wenigstens einer, abweichender Zweig genannt, wenigstens eine Krümmung (3, 3', 25, 45, 75, 77, 106, 116, 133, 137, 140) bildet, wo er in einem rechten Winkel in Bezug auf die parallelen Zweige einer Minimalgruppe von parallelen Zweigen abweicht, und durch einen Zweig, lotrechter Zweig genannt, verlängert wird, der lotrecht zu diesem abweichenden Zweig ist, wobei die Krümmung im rechten Winkel zwischen diesem abweichenden Zweig und diesem lotrechten Zweig gebildet wird, wobei der abweichende Zweig und der lotrechte Zweig zur selben Materialschicht der integrierten Schaltung gehören, **dadurch gekennzeichnet, dass** sie wenigstens in der Nähe von wenigstens einer Krümmung eines abweichenden Zweigs Folgendes umfasst:
- einen Auftrag, lotrechter Auftrag (5, 5', 27, 47, 80, 107, 117, 130, 134, 141) genannt, von geradlinigem Leitermaterial lotrecht zu den parallelen Zweigen zwischen dem abweichenden Zweig in unmittelbarer Nähe der Krümmung und einem so mit diesem Abweichungszweig verbundenen parallelen Zweig,
- einen Auftrag, geneigter Auftrag (9, 9', 39, 60, 84, 91, 92, 111, 114, 115, 131, 136, 143) genannt, des Leitermaterials zwischen einem Punkt, erster Verbindungspunkt genannt, des lotrechten Zweigs und einem Punkt, zweiter Verbindungspunkt genannt, eines so mit diesem lotrechten Zweig verbundenen parallelen Zweigs, wobei dieser geneigte Auftrag wenigstens oberhalb von dem abweichenden Zweig geneigt und von diesem und von jeder anderen dazwischen liegenden Bahn isoliert ist, oberhalb derer dieser geneigte Auftrag zwischen den Verbindungspunkten durch eine Isoliermaterialschicht passieren muss,
- einen Schnitt (8, 8', 30, 62, 83, 122) des lotrechten Zweigs zwischen dem genannten ersten Verbindungspunkt und der Krümmung,
- einen Schnitt (7, 7', 38, 59, 82) in unmittelbarer Nähe zum zweiten Verbindungspunkt auf einem Abschnitt des parallelen Zweigs, der diesen zweiten Verbindungspunkt aufweist, der an dem geneigten Auftrag angrenzt und einen spitzen Winkel mit der Geraden bildet, die durch die Verbindungspunkte dieses geneigten Auftrags verläuft, so dass die Ein-/Ausgänge von Bahnen, die diese parallelen Zweige umfassen, mittels dieser Aufträge und Schnitte in Bezug auf die Aus-/Eingänge derselben Bahnen invertiert werden.

11. Schaltung nach Anspruch 10, **dadurch gekennzeichnet, dass** die Aufträge (5, 5', 27, 47, 80, 107, 117, 130, 134, 141, 9, 9' , 39, 60, 84, 91, 92, 111, 114, 115, 131, 136, 143) oberhalb einer oberen Isolierschicht der Schaltung gebildet werden und mit den Zweigen durch Anschlussinseln verbunden werden, die durch wenigstens diese obere Isolierschicht verlaufen.

12. Schaltung nach Anspruch 10 oder 11, **dadurch gekennzeichnet, dass** die parallelen Zweige (1, 2, 1', 2', 21 bis 24, 71 bis 74, 101 bis 105) zur selben Materialschicht der integrierten Schaltung gehören, der abweichende Zweig sich am weitesten außen in dieser Schicht in Bezug auf die parallelen Zweige der Minimalgruppe befindet und in einem rechten Winkel zur Außenseite dieser parallelen Zweige hin abweicht, wobei sich der lotrechte Zweig in dieser Schicht von der Krümmung zur Außenseite der parallelen Zweige der Minimalgruppe entfernt.

13. Schaltung nach einem der Ansprüche 10 bis 12, **dadurch gekennzeichnet, dass** wenigstens ein geneigter Auftrag (9, 9', 39, 60, 84, 111, 131, 136, 143) von einem einzigen geradlinigen Segment gebildet wird, das in Bezug auf die Richtung von parallelen Zweigen geneigt ist.

14. Schaltung nach einem der Ansprüche 10 bis 12, **dadurch gekennzeichnet, dass** wenigstens ein geneigter Auftrag (91, 92, 114, 115) von zwei geradlinigen Segmenten gebildet wird, von denen eines (92, 115) lotrecht zur Richtung der parallelen Zweige verläuft.
